# EUROPEAN PATENT APPLICATION

(11) **EP 1 241 783 A1**
(43) Date of publication of application: **18.09.2002**
(21) Application number: 02290599.6
(22) Date of filing: 11.03.2002
(51) Int. Cl.: H03H 9/02

(54) **Surface acoustic wave device and communications apparatus including the same**

(30) Priority: 14.03.2001 JP 2001071759; 07.01.2002 JP 2002000289
(71) Applicant: Murata Manufacturing Co., Ltd., Nagaokakyo-shi Kyoto-fu 617-8555 (JP)
(72) Inventor: Taga, Shigeto, c/o Murata Manufacturing Co., Ltd, Nagaokakyo-shi, Kyoto-fu 617-8555 (JP)
(74) Representative: Orian, Yvette Suzanne

(57) **Abstract**

A surface acoustic wave device is constructed and manufactured using a flip chip bonding method, such that stress produced due to a temperature change in the bonded portion between a surface acoustic wave element and an electronic component package (2) is minimized. The surface acoustic wave device includes a piezoelectric substrate (1) bonded to the electronic component package (2) via metal bumps (3c,3m), wherein the piezoelectric substrate (1) has a substantially rectangular bonding surface on which the metal bumps (3c,3m) are provided, and has different linear thermal expansion coefficients along the directions of two sides of the bonded surface, and the maximum distance (L1) between the metal bumps (3c) arranged in one of the two side directions in which there the piezoelectric substrate (1) and the package (2) have a greater difference between the linear thermal expansion coefficients is less than the maximum distance (L2) between the metal bumps (3c) arranged in the other side direction in which the piezoelectric substrate (1) and the package (2) have a smaller difference between the linear thermal expansion coefficients.

## Description

### BACKGROUND OF THE INVENTION

### 1. Field of the Invention

The present invention relates to a surface acoustic wave device including a piezoelectric substrate which has metal bumps provided on an electrode pad disposed on the piezoelectric substrate, and which is bonded to an internal electrode pattern of an electronic component package made of a ceramics material or other suitable material via a flip chip method or other suitable method, and a communications apparatus including such a novel surface acoustic wave device.

### 2. Description of the Related Art

Electronic components used in portable communications terminals have recently been required to be decreased in size and height (thickness) while also achieving sufficient miniaturization and improvement in the function of the portable communications terminals. Among the electronic components used in portable communications terminals, a surface acoustic wave device is one of the most important electronic components that must be decreased in size and height.

In order to achieve decreased size and height of a surface acoustic wave device, a flip chip method is used as a method of assembling the surface acoustic wave device. The flip chip method for assembling the surface acoustic wave device is a method in which metal bumps are previously provided on an electrode pad of the surface acoustic wave device, and a functional surface of the surface acoustic wave device is pressed on an electronic component package opposite thereto to bond the metal bumps to an electrode pattern provided on the mounting surface of the electronic component package.

Prior to the flip chip method, a method referred to as a "wire bonding method" hereinafter was commonly used. In the wire bonding method, a surface acoustic wave device is fixed to an electronic component package with an adhesive to provide electrical conduction with an electronic component using a metal wire made of Al or Au.

When the flip chip method is used, the metal bumps must be provided with mechanical strength and electrical conduction that is sufficient to fix the surface acoustic wave device to the electronic component package, as compared with a structure using the wire bonding method. Therefore, the bonded portion between the metal bumps and the surface acoustic wave device or between the metal bumps and the electronic component package must have outstanding reliability. The occurrence of separation in the bonded portion causes disconnection of electric conduction which causes damage to the surface acoustic wave device.

In the surface acoustic wave device, in general, lithium tantalate and lithium niobate are commonly used for a piezoelectric substrate, and alumina ceramics materials are commonly used for the electronic component package. In this case, the surface acoustic wave device and the electronic component package have different linear thermal expansion coefficients.

Therefore, in the flip chip method, the surface acoustic wave device and the electronic component package having different linear thermal expansion coefficients are bonded together via the metal bumps. However, when materials having different linear thermal expansion coefficients are bonded together and subjected to a temperature change, stress occurs in the bonded portion due to the difference between the linear thermal expansion coefficients. As a result, when the surface acoustic wave device using the flip chip method is subjected to a large temperature difference or repeated temperature changes, the device experiences the problem of breaking of the bonded portion due to the stress.

The wire bonding method causes less of the above-described problem. This is because a surface acoustic wave device made using the wire bonding method includes an adhesive provided on a sufficient area of the back of the surface acoustic wave element to prevent separation of the surface acoustic wave device from the electronic component package. In some cases, the structure using the wire bonding method also uses additional techniques to relieve stress, for example, using an adhesive material which becomes soft after curing. Furthermore, in the electrically conductive portion, a metal wire connecting the surface acoustic wave element and the electronic component package is long, thin, soft, and looped, and thus stress due to the difference between the linear thermal expansion coefficients is sufficiently relieved by deformation of the metal wire. For these reasons, the wire bonding method causes no problem of stress due to a temperature change.

Furthermore, the surface acoustic wave device cannot include a material that inhibits vibration of the functional plane of the surface acoustic wave element. Thus, an under film resin generally used in a semiconductor device cannot be used in surface acoustic wave devices to suppress stress caused by the difference between linear thermal expansion coefficients.

As described above, in the flip chip method, the surface acoustic wave element is fixed and electrically connected to the electronic component package only by the metal bumps which have a relatively small bonding area. Therefore, the problems caused by stress due to the difference between linear thermal expansion coefficients are critical.

### SUMMARY OF THE INVENTION

In order to overcome the above-described problems, preferred embodiments of the present invention provide a surface acoustic wave device that is made using the flip chip method and has greatly decreased stress produced in a bonded portion between a surface acoustic wave element and an electronic component package due to a temperature change, and a communications apparatus including such a novel surface acoustic wave device.

A surface acoustic wave device according to a preferred embodiment of the present invention includes a piezoelectric substrate bonded to a package via metal bumps, wherein the piezoelectric substrate has different linear thermal expansion coefficients in two different directions of a bonded surface on which the metal bumps are provided, and the maximum distance between the metal bumps arranged in one of the two directions in which the piezoelectric substrate and the package have a larger difference between the linear thermal expansion coefficients is shorter than the maximum distance between the metal bumps arranged in the other direction in which the piezoelectric substrate and the package have a smaller difference between the linear thermal expansion coefficients.

In another preferred embodiment of the present invention, a surface acoustic wave device includes a piezoelectric substrate bonded to a package via metal bumps, wherein the piezoelectric substrate has a substantially rectangular bonding surface on which the metal bumps are provided, and has different linear thermal expansion coefficients along the directions of two sides of the bonding surface, and the maximum distance between the metal bumps arranged in one of the two side directions in which the piezoelectric substrate and the package have a larger difference between the linear thermal expansion coefficients is shorter than the maximum distance between the metal bumps arranged in the other side direction in which the piezoelectric substrate and the package have a smaller difference between the linear thermal expansion coefficients.

In the above-described unique construction, the metal bumps are arranged such that the difference between the linear thermal expansion coefficients of the piezoelectric substrate and the package is such that the maximum distance between the metal bumps arranged in one of the two side directions in which the piezoelectric substrate and the package have a larger difference between the linear thermal expansion coefficients is shorter than the maximum distance between the metal bumps arranged in the other side direction in which the piezoelectric substrate and the package have a smaller difference between the linear thermal expansion coefficients.

This decreases the difference between the displacements of the piezoelectric substrate and the package, which are caused by a temperature change, and minimizes stress produced in the metal bumps due to the temperature change. As a result, disconnections due to a temperature change in the bonded portion between the piezoelectric substrate and the package are prevented.

Therefore, a surface acoustic wave element is securely fixed to the package and electric conduction therebetween is reliably achieved via only the metal bumps having a relatively small bonded area. Thus, greatly improved reliability of the surface acoustic wave device having decreased size and thickness is achieved using the flip chip method.

In the surface acoustic wave device according to another preferred embodiment of the present invention, at least three metal bumps are preferably arranged near any of the four corners of the bonding surface of the piezoelectric substrate.

In the above-described unique construction, the metal bumps that bond the surface acoustic wave element to the package are provided at a maximum distance on the piezoelectric substrate without a deviation.

Therefore, the surface acoustic wave element is securely fixed to the package and stable electric conduction is achieved via only the metal bumps having a relatively small bonded area. Thus, the reliability of the surface acoustic wave device made using the flip chip method is greatly improved.

In the surface acoustic wave device according to another preferred embodiment of the present invention, the piezoelectric substrate is preferably made of lithium tantalate or lithium niobate as a main component and the package is preferably made of alumina ceramics material as a main component.

Lithium tantalate and lithium niobate are suitable as the main component of the piezoelectric substrate. Alumina ceramics material is suitable as the main component of the package.

According to another preferred embodiment of the present invention, a communications apparatus is provided that includes at least one surface acoustic wave device according to any of the preferred embodiments of the present invention described above.

According to the above-described unique construction, the surface acoustic wave device is manufactured using the flip chip method, thereby greatly decreasing the size and thickness of the surface acoustic wave device. By providing the surface acoustic wave device according to preferred embodiments of the present invention, the size of the communications apparatus is greatly reduced.

Other features, characteristics, elements and advantages of the present invention will become apparent from the following description of a preferred embodiment thereof with reference to the attached drawings.

### BRIEF DESCRIPTION OF THE DRAWINGS

Fig. 1A is a schematic plan view illustrating a surface acoustic wave device according to a preferred embodiment of the present invention.

Fig. 1 B is a side view of the surface acoustic wave device shown in Fig. 1A.

Fig. 2 is a schematic block diagram showing a communications apparatus including the surface acoustic wave device shown in Figs. 1A and 1B.

### DETAILED DESCRIPTION OF PREFERRED EMBODIMENT

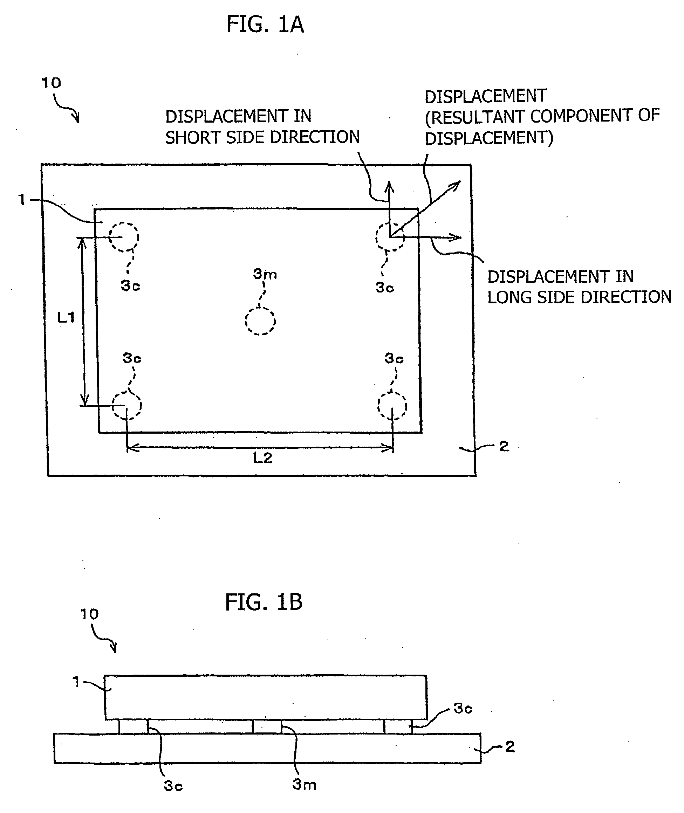

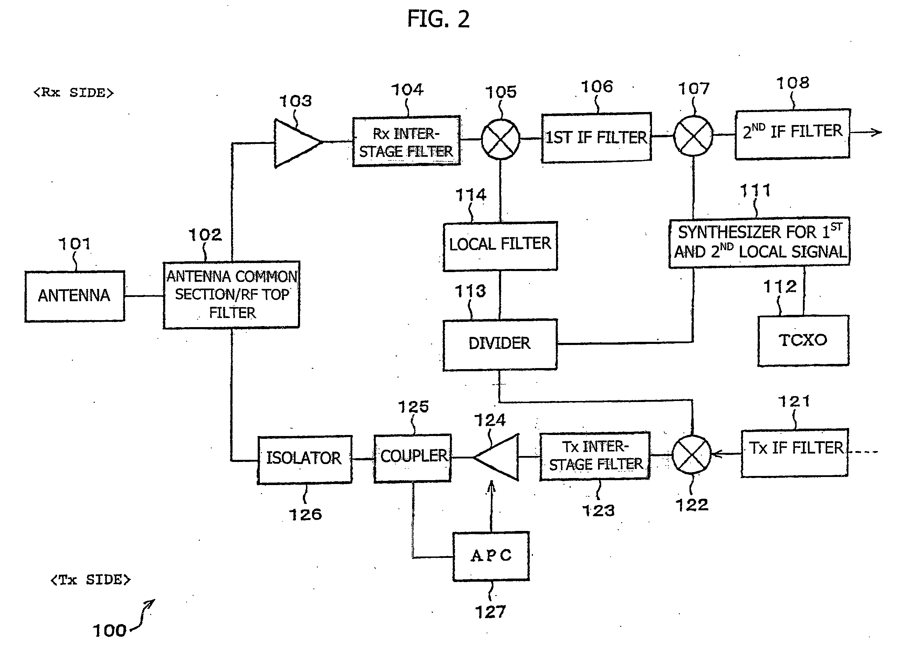

A preferred embodiment of the present invention will be described with reference to Figs. 1A, 1B and 2.

As shown in Figs. 1A and 1B, a surface acoustic wave device 10 according to this preferred embodiment includes a surface acoustic wave element having a comb-like electrode (not shown in the drawing) and electrode pads provided on a surface (an electrode formation surface or bonding surface) of a piezoelectric substrate 1, and which is bonded to an electronic component package (package) 2 via metal bumps 3c and 3m.

The piezoelectric substrate 1 is preferably made of lithium tantalate (or lithium niobate), and includes the electrode pads which are disposed at positions of the surface (bonding surface) facing the electronic component package 2, at which the metal bumps 3c and 3m are provided. The electronic component package 2 is preferably made of alumina ceramics material as a main component, and the metal bumps 3c and 3m are preferably made of Au as a main component.

In the surface acoustic wave device 10, the piezoelectric substrate 1 is preferably substantially rectangular or substantially square. The piezoelectric substrate 1 is configured such that the direction of the short side defines a side direction in which the piezoelectric substrate 1 and the electronic component package 2 have a larger difference between the linear thermal expansion coefficients. The positions of the metal bumps 3c are selected such that the maximum distance (L1) between the metal bumps 3 in the shorter side direction is less than the maximum distance (L2) in the longer side direction.

Specifically, for example, as shown in Fig. 1, the four metal bumps 3c are provided at the four corners of the substantially rectangular piezoelectric substrate 1, and the metal bump 3m is disposed at the approximate center thereof. The center distance L1 between metal bumps 3c in the short side direction is preferably, for example, about 1.0 mm, and the center distance L2 of the metal bumps 3c in the long side direction is preferably, for example, about 1.5 mm.

The surface acoustic wave device 10 is configured such that the linear thermal expansion coefficient of the electronic component package 2 (alumna ceramics material) is preferably, for example, about 7 x 10⁻⁶/°C, the linear thermal expansion coefficient of the piezoelectric substrate 1 (lithium tantalate) in the long side direction is preferably, for example, about 8 x 10⁻⁶/°C, and the linear thermal expansion coefficient of the piezoelectric substrate 1 in the short side direction is preferably, for example, about 14 x 10⁻⁶/°C. The longer side and the shorter side of the piezoelectric substrate 1 are determined based on the outer dimensions of the electrode formation surface.

The linear thermal expansion coefficient of the piezoelectric substrate 1 will be described below. The linear thermal expansion coefficients of lithium tantalate (LT) and lithium niobate (LN) vary according to the cutting angle and crystal orientation. Also, the linear thermal expansion coefficients are described as physical property values for crystal orientation.

Therefore, with the above-described materials for the substrate of the surface acoustic wave element, a crystal orientation that can be used as the propagation direction of a surface acoustic wave is limited to some extent within a range. More specifically, the substrate of the surface acoustic wave element preferably has a crystal orientation in which the linear thermal expansion coefficient is larger in the propagation direction of the surface acoustic wave, and smaller in the direction that is substantially perpendicular to the propagation direction.

Specifically, the substrate of the surface acoustic wave element preferably has a crystal orientation in which the linear thermal expansion coefficient is preferably, for example, about 14 x 10⁻⁶/°C to about 17 x 10⁻⁶/°C in the propagation direction of the surface acoustic wave, and preferably, for example, about 6 x 10⁻⁶/°C to about 9 x 10⁻⁶/°C in the direction that is substantially perpendicular to the propagation direction.

In the surface acoustic wave device 10 having the above-described configuration, the piezoelectric substrate 1 and the electronic component package 2 have different linear thermal expansion coefficients, thereby producing stress in the metal bumps 3c and 3m on the bonding surface when a temperature change is applied to the surface acoustic wave device 10. The maximum stress occurs between the metal bumps 3c disposed at the maximum distance. Therefore, consideration is now given to the stress produced in the metal bumps 3c at the four corners, which are most affected by the temperature change.

The stress produced in the metal bumps 3c due to the temperature change is due to the difference between the displacement of the electronic component package 2 and the displacement of the piezoelectric substrate 1, which are caused by the temperature change. The magnitude of the stress is approximately proportional to the difference between the displacements.

No stress occurs at the center (near the metal bump 3m) even when the temperature changes. Therefore, the displacements of the piezoelectric substrate 1 and the electronic component package 2 produced due to a temperature change at the position of each of the metal bumps 3c disposed at the four corners are calculated with respect to the center of the piezoelectric substrate 1.

Table 1 shows the displacements of the electronic component package 2 and the piezoelectric substrate 1 at the location of each of the metal bumps 3c at the four corners, and the difference between the displacements with respect to the center the surface acoustic wave element (the piezoelectric substrate 1) when a temperature change was applied to the surface acoustic wave device 10 shown in Figs. 1A and 1B. Table 1 also shows the displacements of the piezoelectric substrate and the electronic component package at the location of each of the metal bumps 3c at the four corners, and the difference between the displacements in a comparative example in which the surface acoustic wave element was configured such that the linear thermal expansion coefficients in the longer side and shorter side directions are reversed relative to those in the surface acoustic wave device shown in Figs. 1A and 1B.

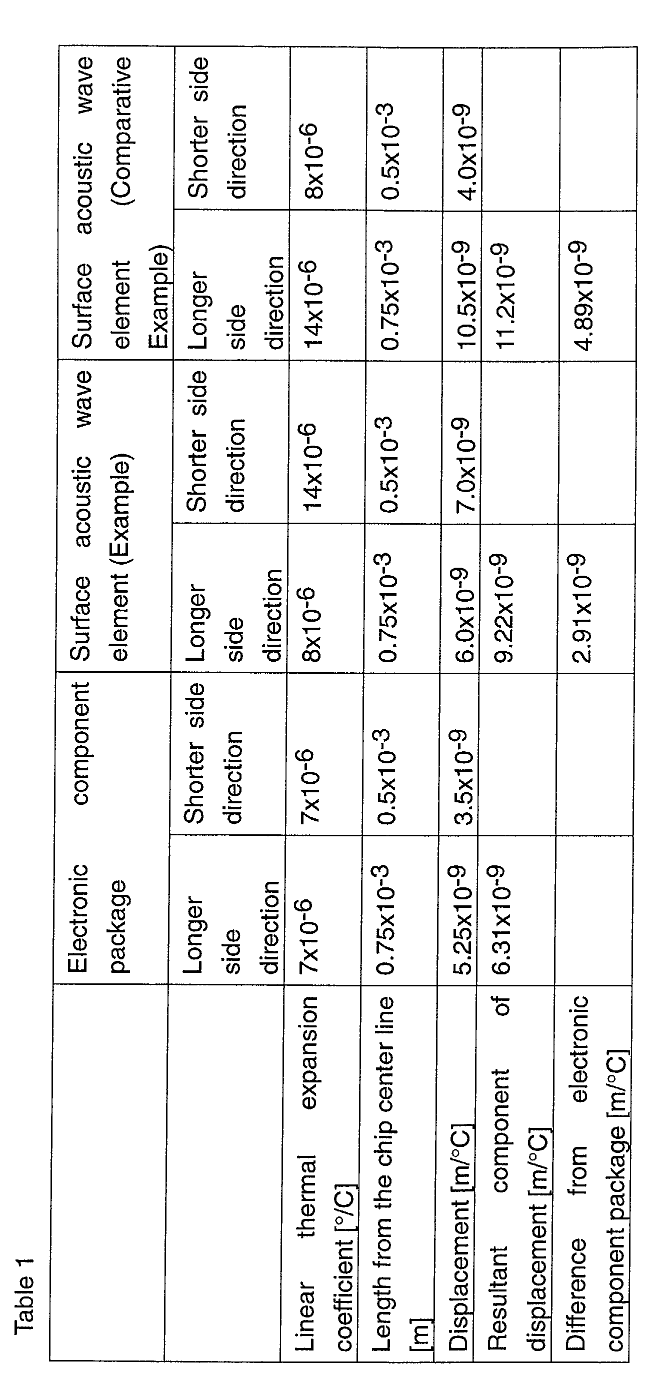

In Table 1, "length from the chip center line" represents the distance from the center of the piezoelectric substrate 1 to each of the four corner metal bumps 3c in each of the side directions. "Displacement" is determined as the product of the linear thermal expansion coefficient and the length from the chip center line for each of the side directions. Furthermore, "resultant component of displacement" is determined as the mean square of the displacements in the side directions.

Table 1 indicates that in the surface acoustic wave device according to preferred embodiments of the present invention, the difference between the displacements of the surface acoustic wave element and the electronic component package 2 is significantly decreased to about 60% of that in the comparative example in which the linear thermal expansion coefficients in the longer side and shorter side directions are reversed to those according to preferred embodiments of the present invention. Thus, in the structure according to preferred embodiments of the present invention, stress produced in the bonded portion (the metal bumps 3c) due to a temperature change is much lower than that in the structure of the comparative example.

As described above, in the surface acoustic wave device 10, the direction of the plane of the piezoelectric substrate 1 in which the distance between the metal bumps 3c is greater coincides with the direction in which the piezoelectric substrate 1 and the electronic component 2 have a smaller difference between the linear thermal expansion coefficients.

As shown in Fig. 1, the piezoelectric substrate 1 having a substantially rectangular shape is configured such that the side direction in which the distance between the metal bumps 3 is greater coincides with the direction in which the linear thermal expansion coefficient is smaller. In this case, the maximum distance between the metal bumps 3 arranged in the side direction in which the piezoelectric substrate 1 and the electronic component package 2 have a greater difference between the linear thermal expansion coefficients is shorter than the maximum distance between the metal bumps 3 arranged in the side direction in which the piezoelectric substrate 1 and the electronic component package 2 have a smaller difference between the linear thermal expansion coefficients.

This greatly decreases the difference between the displacements of the piezoelectric substrate 1 and the electronic component package 2, which are produced by a temperature change. Therefore, stress produced in the metal bumps 3 due to a temperature change is minimized. As a result, the occurrence of disconnection due to a temperature change in the bonded portion between the piezoelectric substrate 1 and the electronic component package 2 is prevented, and thus the reliability of the surface acoustic wave device 10 is greatly improved.

A communications apparatus 100 including the surface acoustic wave device 10 is described below with reference to Fig. 2.

The communications apparatus 100 preferably includes a receiver for receiving signals, including: an antenna 101, an antenna common section/RF Top filter 102, an amplifier 103, an Rx inter-stage filter 104, a mixer 105, a 1st IF filter 106, a mixer 107, a 2nd IF filter 108, a synthesizer for 1st+2nd local signal 111, a TCXO (temperature compensated crystal oscillator) 112, a divider 113, and a local filter 114.

The communications apparatus 100 further includes a transceiver for transmitting signals, including: the antenna 101, the antenna common section/RF Top filter 102, a Tx IF filter 121, a mixer 122, a Tx inter-stage filter 123, an amplifier 124, a coupler 125, an isolator 126, and an APC (automatic power control) 127.

The above-described surface acoustic wave device 10 is suitably used for any of the Rx inter-state filter 104, the 1st IF filter 106, the Tx IF filter 121 and the Tx inter-stage filter 123. Since the surface acoustic wave device 10 is manufactured using the flip chip bonding method, the size and thickness thereof is greatly reduced. Therefore, by providing the surface acoustic wave device 10, miniaturization of the communications apparatus 100 is achieved. Accordingly, the communications apparatus 100 is optimum for mobile communications.

The present invention is not limited to preferred embodiments described above, and various changes can be made within the scope of the present invention. For example, the present invention can be constructed in various ways as described below.

In the surface acoustic wave device 10, the piezoelectric substrate 1 has different linear thermal expansion coefficients in two different directions along the electrode formation surface (bonding surface), and the metal bumps 3c are disposed on the piezoelectric substrate 1 such that the maximum distance between the metal bumps 3c disposed in the direction in which the piezoelectric substrate 1 and the electronic component package 2 have a greater difference between the linear thermal expansion coefficients is shorter than the maximum distance between the metal bumps 3c disposed in the other direction in which the piezoelectric substrate 1 and the electronic component package 2 have a smaller difference between the linear thermal expansion coefficients. The two directions may respectively coincide with the direction in which the difference between the linear thermal expansion coefficients of the piezoelectric substrate 1 and the electronic component package 2 is maximum and the direction in which the difference is minimum. The shapes of the piezoelectric substrate 1 and the electronic component package 2 may be determined based on the direction in which the difference between the linear thermal expansion coefficients is maximum and the direction in which the difference is minimum, and on the differences in the linear thermal expansion coefficients in these directions.

Although the piezoelectric substrate 1 shown in Fig. 1 has a substantially rectangular shape, the shape of the piezoelectric substrate 1 is not limited to this shape. Preferred materials for the piezoelectric substrate 1 include lithium tantalate and lithium niobate, but other piezoelectric materials may be used.

Although, an example in which five metal bumps 3c and 3m are provided is described above, the number of the metal bumps 3c and 3m is not limited. The example includes metal bumps 3c and 3m disposed at the four corners of the piezoelectric substrate 1 as described above, however, the metal bumps 3c and 3m can be disposed at any desired positions. Also, Au is used as the material of the metal bumps 3, however, a metal containing Au, solder or other suitable material may be used.

Although the electronic component package 2 having a plate structure is described above, a cavity structure may be used. Also, the electronic component package 2 may be made of a material other than alumina ceramics material, and may have anisotropy in the linear thermal expansion coefficient, as in the piezoelectric substrate 1.

As described above, a surface acoustic wave device according to a preferred embodiment of the present invention includes a piezoelectric substrate which is bonded to a package via metal bumps, wherein the piezoelectric substrate has different linear thermal expansion coefficients in two different directions of the bonding surface on which the metal bumps are provided, and the maximum distance between the metal bumps disposed in one of the two directions in which the piezoelectric substrate and the package have a greater difference between the linear thermal expansion coefficients is less than the maximum distance between the metal bumps disposed in the other direction in which the piezoelectric substrate and the package have a smaller difference between the linear thermal expansion coefficients.

Alternatively, a surface acoustic wave device according to the present invention includes a piezoelectric substrate which is bonded to a package via metal bumps, wherein the piezoelectric substrate has a substantially rectangular bonding surface on which the metal bumps are provided and different linear thermal expansion coefficients in the two side directions of the bonding surface, and the maximum distance between the metal bumps disposed in one of the two side directions in which the piezoelectric substrate and the package have a greater difference between the linear thermal expansion coefficients is less than the maximum distance between the metal bumps arranged in the other side direction in which the piezoelectric substrate and the package have a smaller difference between the linear thermal expansion coefficients.

Therefore, the metal bumps are positioned based upon the difference between the linear thermal expansion coefficients of the piezoelectric substrate and the package. Thus, the difference between the displacements of the piezoelectric substrate and the package, which are caused by a temperature change, are decreased to minimize stress produced in the metal bumps due to the temperature change. As a result, the occurrence of disconnection caused by a temperature change in the bonded portion between the piezoelectric substrate and the package is reliably prevented.

Thus, a surface acoustic wave element is securely fixed to the package, and stable electric conduction is achieved via only the metal bumps having a relatively small bonded area. Therefore, the present invention greatly improves reliability of the surface acoustic wave device having greatly decreased size and thickness via use of the flip chip bonding method.

As described above, in the surface acoustic wave device of the present invention, at least three metal bumps are arranged near any of the four corners of the bonded surface of the piezoelectric substrate.

Furthermore, the metal bumps for bonding the substantially rectangular piezoelectric substrate, i.e., the surface acoustic wave element, to the package are arranged at a maximum distance on the piezoelectric substrate without deviation.

Thus, a surface acoustic wave element is securely fixed to the package, and stable electric conduction is achieved via only the metal bumps having a relatively small bonded area. Therefore, the present invention greatly improves reliability of the surface acoustic wave device having greatly decreased size and thickness via use of the flip chip bonding method.

As described above, in the surface acoustic wave device according to preferred embodiments of the present invention, the piezoelectric substrate is preferably made of lithium tantalate or lithium niobate as a main component and the package is preferably made of alumina ceramics material as a main component. Lithium tantalate and lithium niobate are suitable as the main component of the piezoelectric substrate, and alumina ceramics material is suitable as the main component of the package.

As described above, a communications apparatus of the present invention includes the above-described surface acoustic wave device.

Therefore, the surface acoustic wave device manufactured using the flip chip bonding method has decreased in size and thickness. By providing the surface acoustic wave device in the communications apparatus, the communications apparatus is effectively miniaturized.

It should be understood that the foregoing description is only illustrative of the present invention. Various alternatives and modifications can be devised by those skilled in the art without departing from the invention. Accordingly, the present invention is intended to embrace all such alternatives, modifications and variations which fall within the scope of the appended claims.

## Claims

1. A surface acoustic wave device comprising:
a package (2);
a plurality of metal bumps (3c,3m); and
a piezoelectric substrate (1) bonded to the package (2) via the plurality of metal bumps (3c,3m);
wherein the piezoelectric substrate (1) has different linear thermal expansion coefficients in two different directions of a bonding surface of the piezoelectric substrate on which the plurality of metal bumps are provided; and
the maximum distance (L1) between the metal bumps arranged in one of the two directions in which the piezoelectric substrate (1) and the package (2) have a greater difference between the linear thermal expansion coefficients is less than the maximum distance (L2) between the metal bumps arranged in the other direction in which the piezoelectric substrate (1) and the package (2) have a smaller difference between the linear thermal expansion coefficients.

2. A surface acoustic wave device according to Claim 1, wherein at least three of the metal bumps (3c) are disposed near any of four corners of the bonding surface of the piezoelectric substrate (1).

3. A surface acoustic wave device according to Claim 1 or 2, wherein the piezoelectric substrate (1) is made of one of lithium tantalate and lithium niobate as a main component, and the package (2) is made of alumina ceramics material as a main component.

4. A surface acoustic wave device according to Claim 1, 2 or 3, wherein one of the metal bumps (3c) is disposed near each of four corners of the bonding surface of the piezoelectric substrate (1).

5. A surface acoustic wave device according to Claim 1, 2 or 3, wherein at least three of the metal bumps (3c) are disposed near any of four corners of the bonding surface of the piezoelectric substrate (1), and at least one (3m) of the metal bumps is disposed in the approximate center of the bonding surface of the piezoelectric substrate (1).

6. A surface acoustic wave device according to any previous Claim, wherein the piezoelectric substrate (1) is substantially rectangular.

7. A surface acoustic wave device according to any previous Claim, wherein the metal bumps (3c,3m) are made of Au.

8. A surface acoustic wave device according to any one of Claims 1 to 6, wherein the metal bumps (3c,3m) are made of solder.

9. A surface acoustic wave device according to any one of Claims 1 to 6, wherein the metal bumps (3c,3m) are made of a metal containing Au.

10. A surface acoustic wave device according to any previous claim, wherein the piezoelectric substrate (1) has a substantially rectangular bonding surface and the two different directions in which the piezoelectric substrate has different linear thermal expansion coefficients are along the directions of two sides of the bonding surface.

11. A communications apparatus comprising a surface acoustic wave device according to any previous Claim.
